# EUROPEAN PATENT APPLICATION

(11) **EP 4 272 996 A1**
(43) Date of publication of application: **08.11.2023**
(21) Application number: 22734803.4
(22) Date of filing: 04.01.2022
(51) Int. Cl.: B60L 53/60, B60L 53/14, B60L 3/00

(54) **ELECTRIC VEHICLE CHARGING CONTROLLER**

(30) Priority: 04.01.2021 KR 20210000320
(71) Applicant: LG Innotek Co., Ltd., Seoul 07796 (KR)
(72) Inventor: SHIN, Kwang Seob, Seoul 07796 (KR)
(74) Representative: DREISS Patentanwälte PartG mbB
(86) International application number: PCT/KR2022/000096
(87) International publication number: WO 2022/146130

(57) **Abstract**

An electric vehicle charging controller according to an embodiment of the present invention comprises: a switch; a first resistance having a first end connected to a collector terminal of the switch and a second end connected to a first power; a second resistance having a first end connected to a collector terminal of the switch and a second end connected to a signal output terminal; a third resistance having a first end connected to the second end of the second resistance and a second end connected to a first ground terminal; and a diode having a cathode terminal electrically connected to a base terminal of the switch. An emitter terminal of the switch is electrically connected to a second ground terminal of a power supply device.

## Description

### [Technical Field]

An embodiment relates to an electric vehicle charging controller.

### [Background Art]

An eco-friendly vehicle, such as an electric vehicle (EV) or a plug-in hybrid electric vehicle (PHEV), uses electric vehicle supply equipment (EVSE) installed at a charging station to charge a battery.

To this end, an electric vehicle charging controller (EVCC) is mounted inside the EV, communicates with the EV and the EVSE, and controls the charging of the EV.

For example, when the EVCC receives a signal indicating the start of charging from the electric vehicle, the EVCC may control to start charging, and when the EVCC receives a signal indicating the end of charging from the electric vehicle, the EVCC may control to end charging.

A method of charging the electric vehicle may be classified into fast charging and slow charging depending on charging time. In case of fast charging, the battery is charged by direct current supplied by a charger, and in case of slow charging, the battery is charged by alternating current supplied by the charger. Therefore, a charger used for fast charging is called a fast charger or a DC charger, and a charger used for slow charging is called a slow charger or an AC charger.

An electric vehicle charging system uses high-voltage electricity to charge, which may cause safety issues such as an electric shock or a system failure due to reverse current. Therefore, the electric vehicle charging system controls a charging process through various sequences to prevent various problems that may occur during charging in advance, and provides various structures to increase the stability of the system.

However, currently, the electric vehicle charging system is not able to detect or prevent all of the various problems that may occur during the battery charging process, and therefore a solution is required to solve the problems described above.

### [Technical Problem]

An embodiment is directed to providing an electric vehicle charging controller capable of accurately detecting a connection status between an electric vehicle and electric vehicle supply equipment.

The objects to be achieved by the embodiment are not limited to the above-mentioned objects, but also include objects or effects that may be understood from the solutions or embodiments described below.

### [Technical Solution]

An electric vehicle charging controller according to an embodiment of the present invention includes a switch, a first resistor having a first end connected to a collector terminal of the switch and a second end connected to a first power source, a second resistor having a first end connected to the collector terminal of the switch and a second end connected to a signal output terminal, a third resistor having a first end connected to the second end of the second resistor and a second end connected to a first ground terminal, and a diode having a cathode terminal electrically connected to a base terminal of the switch, wherein an emitter terminal of the switch is electrically connected to a second ground terminal of supply equipment.

The switching unit may include a bipolar junction transistor of an NPN type.

The electric vehicle charging controller may further include a capacitor having a first end connected to the signal output terminal and a second end connected to the first ground terminal.

An electric vehicle charging controller according to another embodiment of the present invention includes a signal generation unit configured to generate a switching signal according to a control signal when a first port of electric vehicle supply equipment and a second port of an electric vehicle are connected, a switching unit configured to turn on a switch element connected to one end of the second port through the switching signal, a voltage distribution unit configured to distribute a voltage supplied by a first power source of the electric vehicle by a plurality of resistors electrically connected to the second port, a sensing unit configured to generate a sensing voltage by sensing a voltage distributed by the plurality of resistors, and a determination unit configured to determine a connection status with the electric vehicle supply equipment according to a voltage value of the sensing voltage.

The determination unit may determine that a power source of the supply equipment is shorted to ground when the voltage value of the sensing voltage is zero.

The determination unit may determine that the first port and the second port are not electrically connected when the voltage value of the sensing voltage corresponds to a first reference value.

The determination unit may determine that the first port and the second port are electrically connected when the voltage value of the sensing voltage is less than the first reference value.

When the voltage value of the sensing voltage corresponds to a first reference value while the vehicle is in the process of charging the battery, it may be determined that the battery of the electric vehicle is shorted.

A method of determining a connection status of an electric vehicle charging controller according to still another embodiment of the present invention, includes generating a switching signal according to a control signal when a first port of electric vehicle supply equipment and a second port of an electric vehicle are connected, turning on a switch element connected to one end of the second port through the switching signal, distributing a voltage supplied by a first power source of the electric vehicle by a plurality of resistors electrically connected to the second port, sensing a voltage distributed by the plurality of resistors to generate a sensing voltage, and determining a connection status with the electric vehicle supply equipment according to a voltage value of the sensing voltage.

In the determining of the connection status, a power source of the supply equipment may be determined to be shorted to ground when the voltage value of the sensing voltage is zero.

In the determining of the connection status, the first port and the second port may be determined not to be electrically connected when the voltage value of the sensing voltage corresponds to a first reference value.

In the determining of the connection status, the first port and the second port may be determined to be electrically connected when the voltage value of the sensing voltage is less than the first reference value.

In the determining of the connection status, a battery of the electric vehicle may be determined to be shorted when the sensed voltage value corresponds to the first reference value while the electric vehicle is in the process of charging the battery.

An electric vehicle charging controller according to yet another embodiment of the present invention includes a detection unit configured to output a detection signal based on a voltage applied from a first power source of an electric vehicle, a switching unit configured to electrically connect or disconnect the detection unit and the electric vehicle supply equipment, and to block a current flowing from the electric vehicle supply equipment when a first port of the electric vehicle supply equipment is connected to a second port of the electric vehicle corresponding to the first port, and a switching control unit configured to generate a switching signal to control the switching unit to be turned on and off by using a second power source of the electric vehicle.

The switching unit may include a bipolar junction transistor of an NPN type.

The detection unit may include a first resistor having a first end connected to a collector terminal of the bipolar junction transistor and a second end connected to the first power source, a second resistor having a first end connected to the collector terminal of the bipolar junction transistor, and a third resistor having a first end connected to a second end of the second resistor and a second end connected to a ground terminal of the electric vehicle.

The electric vehicle charging controller may further include a noise removing unit configured to remove a noise signal included in the detection signal.

The noise removing unit may further include a capacitor having a first end connected to the second end of the second resistor and the first end of the third resistor, and a second end connected to the ground terminal of the electric vehicle.

The detection unit may output the detection signal from a node to which the second end of the second resistor and the first end of the third resistor are connected.

The switching control unit may include a fourth resistor having a first end connected to a base terminal of the bipolar junction transistor, a diode element having a cathode terminal connected to a second end of the fourth resistor, a dual bias resistor having a first terminal connected to the ground terminal of the electric vehicle, a second terminal connected to the second power source, a third terminal connected to an anode terminal of the diode element, and a fifth terminal and a sixth terminal connected to each other, and a fifth resistor having a first end connected to a fourth terminal of the dual bias resistor and a second end connected to the second power source

The electric vehicle charging controller may further include a determination unit configured to determine a connection status between the first port and the second port based on the detection signal.

The determination unit may determine that a short to ground has occurred in a line in which the first port and the second port are connected when a magnitude of the detection signal is included within a first voltage range.

The determination unit may determine that the first port and the second port are connected when the magnitude of the detection signal is included in a second voltage range having an average value greater than an average value of the first voltage range.

The determination unit may determine that the first port and the second port are disconnected when the magnitude of the detection signal is included in a third voltage range having an average value greater than the average value of the second voltage range.

The determination unit may determine that a short to battery has occurred when the magnitude of the detection signal is included in the third voltage range during the battery charging of the electric vehicle.

### [Advantageous Effects]

According to an embodiment, the stability of a charging system can be improved by preventing a reverse current flowing from electric vehicle supply equipment from being introduced into a microprocessor or the like on the electric vehicle side.

According to an embodiment, it is possible to determine various connection statuses that may occur while a charging sequence is being performed, thereby improving safety of the charging system.

The various beneficial advantages and effects of the present invention are not limited to the above-mentioned contents and may be more easily understood during the process of describing the specific embodiments of the present invention.

### [Description of Drawings]

FIG. 1 is a view illustrating an electric vehicle charging system according to an embodiment of the present invention.
FIG. 2 is a view illustrating a configuration of the electric vehicle charging system according to the embodiment of the present invention.
FIG. 3 is a block diagram of the electric vehicle charging controller according to the embodiment of the present invention.
FIG. 4 is a view illustrating a circuit configuration of the electric vehicle charging controller according to the embodiment of the present invention.
FIG. 5 is a view illustrating a current flow when a switching unit according to the embodiment of the present invention is in a turned-off state.
FIG. 6 is a view illustrating the current flow when the switching unit according to the embodiment of the present invention is in a turned-on state.
FIG. 7 is a flowchart for describing a port status determination process using the electric vehicle charging controller according to the embodiment of the present invention.
FIG. 8 is a block diagram of an electric vehicle charging controller according to one embodiment of the present invention.
FIG. 9 is a flowchart of a method of determining a connection status of the electric vehicle charging controller according to one embodiment of the present invention.

### [Modes of the Invention]

Hereinafter, exemplary embodiments of the present invention will be described in detail with reference to the accompanying drawings.

However, the technical spirit of the present invention is not limited to some embodiments described herein but may be implemented in various different forms. One or more of the constituent elements in the embodiments may be selectively combined and substituted within the scope of the technical spirit of the present invention.

In addition, unless otherwise specifically and explicitly defined and stated, the terms (including technical and scientific terms) used in the embodiments of the present invention may be construed as the meaning which may be commonly understood by the person with ordinary skill in the art to which the present invention pertains. The meanings of the commonly used terms such as the terms defined in dictionaries may be interpreted in consideration of the contextual meanings of the related technology.

In addition, the terms used in the embodiments of the present invention are for explaining the embodiments, not for limiting the present invention.

In the present specification, unless particularly stated otherwise, a singular form may also include a plural form. The expression "at least one (or one or more) of A, B, and C" may include one or more of all combinations that can be made by combining A, B, and C.

In addition, the terms first, second, A, B, (a), and (b) may be used to describe constituent elements of the embodiments of the present invention.

These terms are used only for the purpose of discriminating one constituent element from another constituent element, and the nature, the sequences, or the orders of the constituent elements are not limited by the terms.

Further, when one constituent element is described as being 'connected', 'coupled', or 'attached' to another constituent element, one constituent element can be connected, coupled, or attached directly to another constituent element or connected, coupled, or attached to another constituent element through still another constituent element interposed therebetween.

In addition, the explanation "one constituent element is formed or disposed above (on) or below (under) another constituent element" includes not only a case in which the two constituent elements are in direct contact with each other, but also a case in which one or more additional constituent elements are formed or disposed between the two constituent elements. In addition, the expression "above (on) or below (under)" may include a meaning of a downward direction as well as an upward direction based on one constituent element.

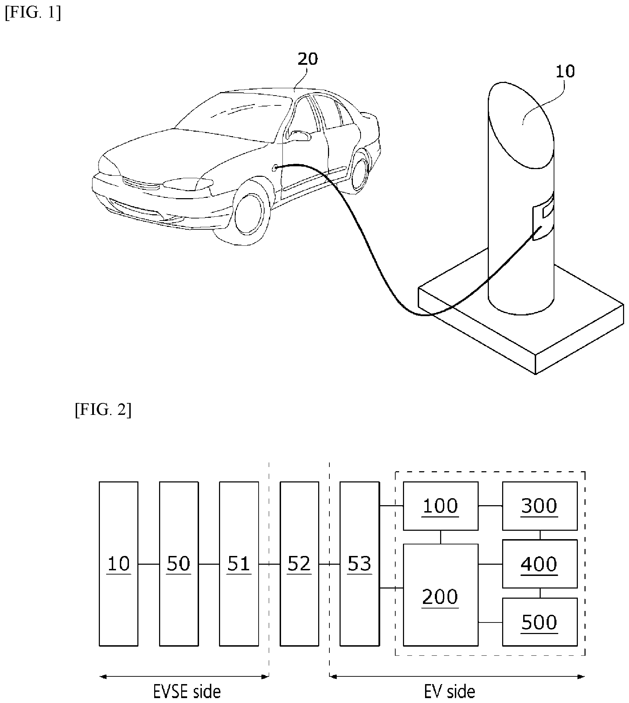

FIG. 1 is a view illustrating an electric vehicle charging system according to an embodiment of the present invention.

The electric vehicle charging system according to the embodiment of the present invention may refer to a system for charging a battery of an electric vehicle powered by electric energy.

With reference to FIG. 1, the electric vehicle charging system according to the embodiment of the present invention may include electric vehicle supply equipment (EVSE) 10 and an electric vehicle (EV) 20.

The electric vehicle supply equipment 10 is a facility that supplies AC power or DC power and may be disposed at a charging station, may be disposed in a home, or may be implemented to be portable. The electric vehicle supply equipment 10 may be used interchangeably with a supply, an AC supply, and a DC supply. The electric vehicle supply equipment 10 may be supplied with AC power or DC power from a main power supply side. The main power supply may include an electrical power system or the like. The electric vehicle supply equipment 10 may transform or convert AC power or DC power supplied from the main power supply and supply the power to the electric vehicle 20.

The electric vehicle 20 means a vehicle that operates by receiving all or part of energy from the mounted battery. The electric vehicle 20 may include a plug-in hybrid electric vehicle (PHEV) that runs in parallel with an engine using fossil fuels as well as an electric vehicle that runs only with electric energy charged in the battery. The battery provided in the electric vehicle 20 may be charged by receiving electric power from the electric vehicle supply equipment 10.

FIG. 2 is a view illustrating a configuration of the electric vehicle charging system according to the embodiment of the present invention.

The electric vehicle charging system according to the embodiment of the present invention may include the electric vehicle supply equipment (EVSE) 10, a cable 50, a connector 51, an inlet 53, a junction box 100, an electric vehicle charging controller (EVCC) 200, a battery 300, a battery management system (BMS) 400, and an electric power control unit (EPCU) 500. The configurations included in the electric vehicle charging system may be divided into a configuration on the electric vehicle supply equipment 10 side (EVSE side) and a configuration on the electric vehicle 20 side (EV side). The configuration on the electric vehicle supply equipment 10 side may include the electric vehicle supply equipment 10, the cable 50, and the connector 51. The configuration on the electric vehicle side may include the inlet 53, the junction box 100, the electric vehicle charging controller 200, the battery 300, the battery management system 400, and the electric power control unit 500. The division is for illustrative purposes only and is not intended to be limiting.

First, the electric vehicle supply equipment 10 supplies electric power to charge the battery 300 of the electric vehicle. The electric vehicle supply equipment 10 may deliver electric power supplied from the main power supply (e.g., the electric power system) to the electric vehicle 20. In this case, the electric vehicle supply equipment 10 may step down or convert the electric power supplied from the main power supply and supply the power to the electric vehicle 20. According to one embodiment, when the electric vehicle supply equipment 10 supplies AC power to the electric vehicle 20, the electric vehicle supply equipment 10 may transform the AC power supplied by the main power supply and supply the transformed AC power to the electric vehicle 20. In another embodiment, when the electric vehicle supply equipment 10 supplies DC power to the electric vehicle 20, the electric vehicle supply equipment 10 may convert the AC power supplied by the main power supply to DC power and supply the DC power to the electric vehicle 20. For transforming or converting electric power, the electric vehicle supply equipment 10 may include an electric power conversion device. According to an embodiment, the electric vehicle supply equipment 10 may include a rectifier, an isolation transformer, an inverter, a converter, and the like.

The electric vehicle supply equipment 10 may include a charging control device for transmitting and receiving various control signals necessary to charge the battery 300 of the electric vehicle 20 and controlling a battery charging process. The charging control device may transmit and receive control signals to and from the electric vehicle 20 and perform the battery charging process. The control signals may include information such as charging preparation, charging termination, proximity detection, etc. The charging control device may include a communication device for communicating with the electric vehicle 20. The communication device may communicate with the electric vehicle 20 using a power line communication (PLC), a controller area network (CAN), or the like. The communication device may be included in the charging control device, or may be configured separately.

Next, the cable 50, the connector 51, and the inlet 53 electrically connect the electric vehicle supply equipment 10 and the electric vehicle.

The cable 50 transmits electric power and signals between the electric vehicle supply equipment 10 and the electric vehicle 20. The cable 50 may include an electric power line that carries electric power, a signal line that transmits control signals related to charging, a ground line that connects to the ground, and the like.

The cable 50 is connected to the electric vehicle supply equipment 10. According to one embodiment, the electric vehicle supply equipment 10 and the cable 50 may be directly connected without any additional connection configuration. According to another embodiment, the electric vehicle supply equipment 10 and the cable 50 may be connected through a combination of a socket-outlet provided on the electric vehicle supply equipment 10 and a plug provided on the cable 50.

The connector 51 may be connected to the cable 50, and the inlet 53 may be provided on the electric vehicle 20. The connector 51 and the inlet 53 may be grouped together and named a coupler. The connector 51 and the inlet 53 are mutually couplable structures, such that the electric vehicle 20 and the electric vehicle supply equipment 10 may be electrically connected through a combination of the connector 51 and the inlet 53. The inlet 53 and the connector 51 may be directly connected, but may also be connected through an adapter 52. According to one embodiment, the adapter 52 may be utilized when the connector 51 and the inlet 53 are not directly connectable due to different charging standards between the electric vehicle supply equipment 10 and the electric vehicle 20. For example, the adapter 52 may be utilized in order to connect the connector 51 of the electric vehicle supply equipment 10 according to the CHAdeMO standard specification to the inlet 53 of the electric vehicle 20 according to the ChaoJi standard specification.

The connector 51 and the inlet 53 may be provided with a plurality of pins that may be coupled to each other. For example, one of the plurality of pins may be a pin for a control pilot (CP) port through which a control pilot (CP) signal is transmitted between the electric vehicle supply equipment 10 and the electric vehicle charging controller 200, another one of the plurality of pins may be a pin for a proximity detection (PD) port that detects whether the connector 51 and the inlet 53 are in proximity, and still another one of the plurality of pins may be a pin for a protective earth (PE) port that is connected to a protective earth of the electric vehicle supply equipment 10. Yet another one of the plurality of pins may be a pin for driving a motor to open a fuel filler flap, yet another one of the plurality of pins may be a pin for sensing a motor, yet another one of the plurality of pins may be a pin for sensing a temperature, yet another one of the plurality of pins may be a pin for sensing an LED, and yet another one of the plurality of pins may be a pin for CAN communication. One of the plurality of pins may be a pin for a line of voltage applied from a collision detection sensor within the electric vehicle 20, another one of the plurality of pins may be a battery pin that provides charging power to the electric vehicle 20, and still another one of the plurality of pins may be a pin for high voltage protection. However, the number and functions of pins are not limited thereto and may be varied.

The junction box 100 delivers electric power supplied from the electric vehicle supply equipment 10 to the battery 300. The electric power supplied by the electric vehicle supply equipment 10 is a high voltage, and when the power is supplied directly to the battery 300, an inrush current may damage the battery 300. The junction box 100 may include at least one relay to prevent damage to the battery due to the inrush current.

The electric vehicle charging controller 200 may control some or all of the processes involved in charging the battery of the electric vehicle 20. The electric vehicle charging controller 200 may also be referred to as an electric vehicle communication controller (EVCC).

The electric vehicle charging controller 200 may communicate with the electric vehicle supply equipment 10. The electric vehicle charging controller 200 may transmit and receive a control command for the battery charging process to and from the electric vehicle supply equipment 10. According to one embodiment, the electric vehicle charging controller 200 may communicate with a charging control device provided in the electric vehicle supply equipment 10 and may transmit and receive a control command for the battery charging process to and from the charging control device.

The electric vehicle charging controller 200 may communicate with the electric vehicle 20. The electric vehicle charging controller 200 may receive a control command for the battery charging process from the electric vehicle 20. According to one embodiment, the electric vehicle charging controller 200 may communicate with the battery management system 400 of the electric vehicle 20 and may also receive a control command for the battery charging process from the battery management system 400. According to another embodiment, the electric vehicle charging controller 200 may communicate with the electric power control unit 500 of the electric vehicle 20 and may receive a control command for the battery charging process from the electric power control unit 500.

The electric vehicle charging controller 200 may be provided with a micro controller unit (MCU), a communication device, a relay device, and the like to perform the above functions.

The battery management system 400 manages an energy state of the battery 300 inside the electric vehicle 20. The battery management system 400 may monitor the usage status of the battery 300 and perform control for efficient energy distribution. For example, the battery management system 400 may transmit the available electric power state of the electric vehicle 20 to a vehicle control unit, the inverter or the like for efficient use of energy. In another example, the battery management system 400 may drive a cooling fan to compensate for voltage variations for each cell of the battery 300 or to maintain the battery 300 at an appropriate temperature.

The electric power control unit 500 is a device that controls an overall motion of the electric vehicle, including a control of the motor. The electric power control unit 500 may include a motor control unit (MCU), a low voltage DC-DC converter (LDC), and the vehicle control unit (VCU). The motor control unit may be named an inverter. The motor control unit may receive DC power from the battery and convert the DC power to three-phase AC power, and may control the motor according to a command from the vehicle control unit. The low voltage DC-DC converter may convert high-voltage power to low-voltage (e.g., 12[V]) power to supply the converted power to each component of the electric vehicle 20. The vehicle control unit serves to maintain performance of the system with respect to the overall electric vehicle 20. The vehicle control unit may perform various functions, such as charging and driving, in conjunction with various devices such as the motor control unit and the battery management system 400.

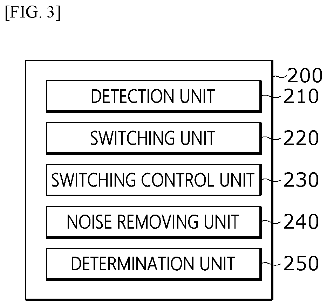

FIG. 3 is a block diagram of the electric vehicle charging controller according to the embodiment of the present invention.

With reference to FIG. 3, the electric vehicle charging controller 200 according to the embodiment of the present invention may include a detection unit 210, a switching unit 220, and a switching control unit 230. The electric vehicle charging controller 200 according to the embodiment of the present invention may further include a noise removing unit 240 and a determination unit 250.

The detection unit 210 may output a detection signal based on a voltage applied from a first power source of the electric vehicle.

The switching unit 220 electrically connects or disconnects the detection unit 210 and the electric vehicle supply equipment, and may block a current flowing from the electric vehicle supply equipment when a first port of the electric vehicle supply equipment is connected to a second port of the electric vehicle corresponding to the first port. According to the embodiment, the first port of the electric vehicle supply equipment and the second port of the electric vehicle may be ports for connector proximity detection. That is, based on the electrical connection between the first port and the second port, the electric vehicle (or the electric vehicle supply equipment) may determine whether the inlet and the connector are connected to each other. The switching unit 220 may include a switching element. The switching element may include a bipolar junction transistor of an NPN type.

The switching control unit 230 may generate a switching signal to control on and off of the switching unit 220 using a control signal of the electric vehicle and a second power source. The control signal may be generated by a microcontroller included in the electric vehicle charging controller 200, but is not limited thereto. The control signal may also be generated by a microcontroller included in the battery management system (BMS) of the electric vehicle. The second power source may be, but is not limited to, a direct current voltage source of 5 [V] or may be the same voltage source as the first power source.

The noise removing unit 240 may remove a noise signal included in the detection signal. According to one embodiment, the noise removing unit 240 may be, but is not limited to, a low pass filter.

The determination unit 250 may determine a connection status between the first port and the second port based on the detection signal. The determination unit 250 may determine that a short to ground has occurred in a line in which the first port and the second port are connected when a magnitude of the detection signal is included within a first voltage range. The determination unit 250 may determine that the first port and the second port are connected when the magnitude of the detection signal is included in a second voltage range having an average value greater than an average value of the first voltage range. The determination unit 250 may determine that the first port and the second port are disconnected when the magnitude of the detection signal is included in a third voltage range having an average value greater than the average value of the second voltage range. The determination unit 250 may determine that a short to battery has occurred when the magnitude of the detection signal is included in the third voltage range during the battery charging of the electric vehicle.

The determination unit 250 may be implemented including a microcontroller, a memory, and the like. The determination unit 250 may be included in the electric vehicle charging controller 200, but is not limited thereto. For example, the determination unit 250 may be implemented by the microcontroller included in the battery management system (BMS) of the electric vehicle.

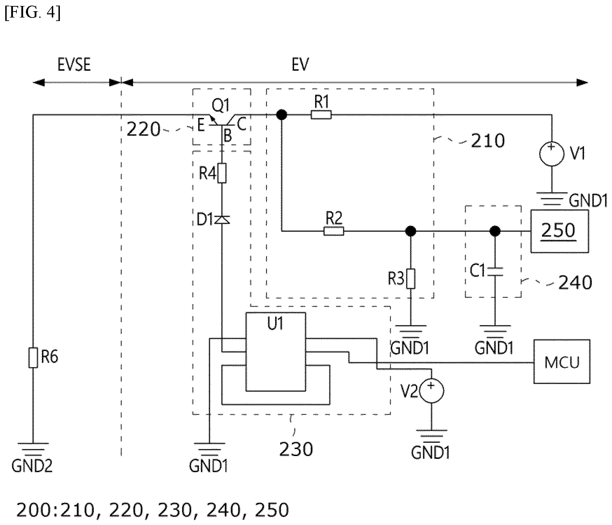

FIG. 4 is a view illustrating a circuit configuration of the electric vehicle charging controller according to the embodiment of the present invention.

With reference to FIG. 4, the electric vehicle charging controller 200 according to the embodiment of the present invention may include the detection unit 210, the switching unit 220, the switching control unit 230, the noise removing unit 240, and the determination unit 250.

The detection unit 210 may include a first resistor R1, a second resistor R2, and a third resistor R3.

The first resistor R1 may have a first end connected to a collector terminal C of a bipolar junction transistor Q1. The first resistor R1 may have the first end connected to a first end of the second resistor R2. The first end of the first resistor R1 may be connected to the same node as the first end of the second resistor R2 and the collector terminal C of the bipolar junction transistor Q1.

The first resistor R1 may have a second end connected to a first power source V1. The first power source V1 may be formed by the battery of the electric vehicle. According to one embodiment, the first power source V1 may be a direct current voltage source of a magnitude of 12 [V].

The first resistor R1 may be implemented by coupling a plurality of resistors in series. For example, the first resistor R1 may be implemented in a configuration where a 1-1 resistor and a 1-2 resistor are connected in series. A first end of the 1-1 resistor may be connected to the collector terminal C of the bipolar junction transistor Q1, a second end of the 1-1 resistor may be connected to a first end of the 1-2 resistor, and a second end of the 1-2 resistor may be connected to the first power source V1. When the first resistor R1 is implemented in a series connection configuration of the 1-1 resistor and the 1-2 resistor, there is an advantage that an electric shock may be buffered even when one of the resistors is damaged.

The second resistor R2 may have a first end connected to the collector terminal C of the bipolar junction transistor Q1. The second resistor R2 may have the first end connected to the first end of the first resistor R1. The first end of the second resistor R2 may be connected to the same node as the first end of the first resistor R1 and the collector terminal C of the bipolar junction transistor Q1.

The second resistor R2 may have a second end connected to a first end of the third resistor R3. The second resistor R2 may have the second end connected to a first end of a capacitor C1. The second resistor R2 may have the second end connected to the determination unit 250. The second end of the second resistor R2, the first end of the third resistor R3, the first end of the capacitor C1, and the determination unit 250 may be connected to the same node. A detection signal detected at the second end of the second resistor R2 may be output to the determination unit 250. For example, when the determination unit 250 is implemented as a microcontroller, the second end of the second resistor R2 is connected to one of the pins disposed on the microcontroller, and the detection signal detected at the second end of the second resistor R2 may be output to one of the pins disposed on the microcontroller.

The third resistor R3 may have the first end connected to the second end of the second resistor R2. The third resistor R3 may have the first end connected to the first end of the capacitor C 1. The third resistor R3 may have the first end connected to the determination unit 250. The first end of the third resistor R3, the second end of the second resistor R2, the first end of the capacitor C1, and the determination unit 250 may be connected to the same node. A detection signal detected at the first end of the third resistor R3 may be output to the determination unit 250. For example, when the determination unit 250 is implemented as a microcontroller, the first end of the third resistor R3 is connected to one of the pins disposed on the microcontroller, and the detection signal detected at the first end of the third resistor R3 may be output to one of the pins disposed on the microcontroller. Since the first end of the third resistor R3 is connected to the second end of the second resistor R2, the detection signal output to the determination unit 250 may be the same signal.

A second end of the third resistor R3 may be connected to a ground terminal GND 1 of the electric vehicle.

The switching unit 220 may include a switching element. The switching element may be the bipolar junction transistor Q1 including an emitter terminal E, the collector terminal C, and a base terminal B.

The bipolar junction transistor Q1 may have the emitter terminal E connected to the electric vehicle supply equipment. For example, the emitter terminal E of the bipolar junction transistor Q1 may be electrically connected to the electric vehicle supply equipment by connecting an inlet on the electric vehicle side and a connector on the electric vehicle charging equipment side to each other. The bipolar junction transistor Q1 may have the emitter terminal E connected to a first end of a sixth resistor R6 of the electric vehicle supply equipment. Meanwhile, a second end of the sixth resistor R6 may be connected to a ground terminal GND2 of the electric vehicle supply equipment.

The bipolar junction transistor Q1 may have the collector terminal C connected to the detection unit 210. The collector terminal C of the bipolar junction transistor Q1 may be connected to the first end of the first resistor R1. The collector terminal C of the bipolar junction transistor Q1 may be connected to the first end of the second resistor R2. That is, the collector terminal C of the bipolar junction transistor Q1 may be connected to the same node as the first end of the first resistor R1 and the first end of the second resistor R2.

The bipolar junction transistor Q1 may have the base terminal B connected to the switching control unit 230. The base terminal B of the bipolar junction transistor Q1 may be connected to a first end of a fourth resistor R4. The bipolar junction transistor Q1 may receive a switching control signal from the switching control unit 230 through the base terminal B.

The switching control unit 230 may be connected to the switching unit 220. The switching control unit 230 may include the fourth resistor (R4), a diode D1, and a dual bias resistor U1.

The fourth resistor R4 may have the first end connected to the base terminal B of the bipolar junction transistor Q1.

The fourth resistor R4 may have a second end connected to a cathode terminal of the diode D 1.

The diode D1 may have the cathode terminal connected to the second end of the fourth resistor R4.

The diode D1 may have an anode terminal connected to a third terminal of the dual bias resistor U1. A reverse voltage that may be applied to the dual bias resistor U1 and the like through the base terminal B of the bipolar junction transistor Q1 may be blocked by connecting the cathode terminal of the diode D1 to the second end of the fourth resistor R4 and connecting the anode terminal to the dual bias resistor U1.

The dual bias resistor U1 may include a plurality of terminals. For an example, the dual bias resistor U1 may include six terminals.

The dual bias resistor U1 may have a first terminal connected to the ground terminal GND 1 of the electric vehicle.

The dual bias resistor U1 may have a second terminal connected to the second power source V2.

The dual bias resistor U1 may have a third terminal connected to the anode terminal of the diode D1. The switching control signal may be output through the third terminal of the dual bias resistor U1.

The dual bias resistor U1 may have a fourth terminal connected to a microcontroller (MCU). The dual bias resistor U1 may have the fourth terminal connected to one of pins disposed on the microcontroller. In this case, the microcontroller may be the same as the microcontroller of the determination unit 250.

The dual bias resistor U1 may have a fifth terminal and a sixth terminal connected to each other.

The dual bias resistor U1 may generate a switching signal through a control signal input through the fourth terminal and electric power of the second power source V2 input through the second terminal. A reverse voltage that may be applied to the microcontroller or the like connected to the fourth terminal may be blocked by using the dual bias resistor U1. That is, dual protection for the microcontroller may be possible through the diode D1 and the dual bias resistor U1.

The noise removing unit 240 may be connected to the detection unit 210. The noise removing unit 240 may include the capacitor C1.

The capacitor C 1 may have the first end connected to the second end of the second resistor R2. The capacitor C1 may have the first end connected to the first end of the third resistor R3. The capacitor C1 may have the first end connected to the determination unit 250. The first end of the capacitor C1, the first end of the third resistor R3, the second end of the second resistor R2, and the determination unit 250 may be connected to the same node. The capacitor C1 may remove a noise included in the detection signal output from the first end of the third resistor R3 and the second end of the second resistor R2. For example, the capacitor C1 may protect the determination unit 250 implemented as a microcontroller by removing a high frequency signal included in the detection signal.

The capacitor C1 may have the second end connected to the ground terminal GND 1 of the electric vehicle.

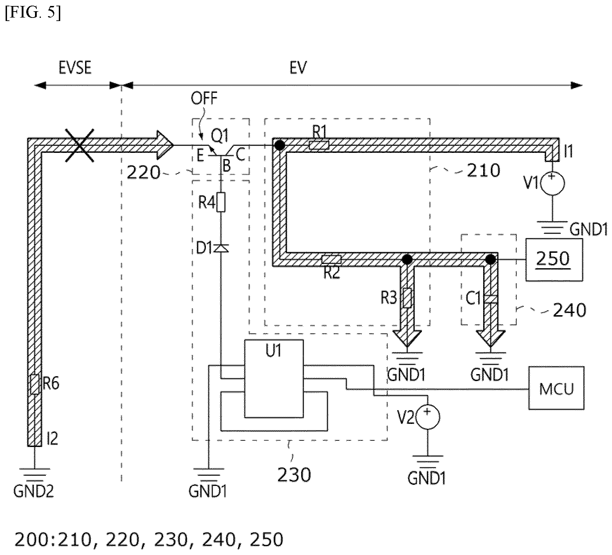

FIG. 5 is a view illustrating a current flow when the switching unit according to the embodiment of the present invention is in a turned-off state.

As illustrated in FIG. 5, when the switching element is turned off, the emitter terminal E and the collector terminal C may be electrically open.

Accordingly, a current I1 formed by the electric power supply of the first power source V1 flows through a closed circuit connected to the first resistor R1, the second resistor R2, the third resistor R3, and the capacitor C1. That is, the current I1 formed by the electric power supply of the first power source V1 may not flow to the electric vehicle supply equipment. In addition, when the switching element is turned off, a current I2 may not flow from the electric vehicle supply equipment to the detection unit 210 side because the emitter terminal E and the collector terminal C are electrically open. Accordingly, the first port of the electric vehicle supply equipment and the second port of the electric vehicle may be electrically isolated.

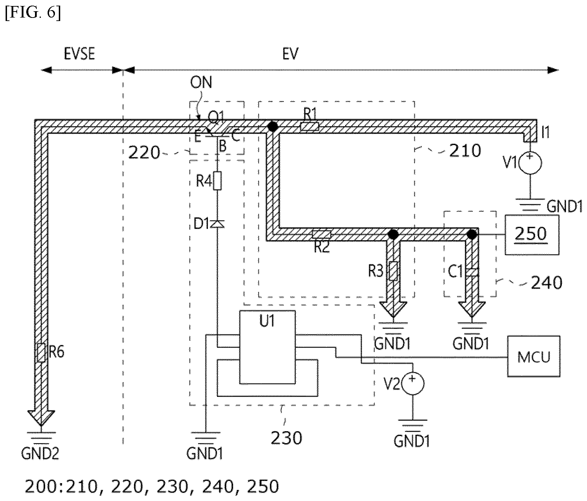

FIG. 6 is a view illustrating a current flow when the switching unit according to the embodiment of the present invention is in a turned-on state.

As illustrated in FIG. 6, when the switching element is turned on, the emitter terminal E and the collector terminal C may be electrically shorted.

Accordingly, a current formed by an electric power supply of the first power source V1 flows through a closed circuit including the first resistor R1, the second resistor R2, the third resistor R3, and the capacitor C1, as well as the sixth resistor R6 of the electric vehicle supply equipment. In this case, since the closed circuit is formed between the electric vehicle charging controller 200 and the electric vehicle supply equipment, an abnormal current or the like may occur and thus a reverse current may flow from the electric vehicle supply equipment to the electric vehicle charging controller 200. This may cause an erroneous determination of the connection status between the first and the second ports.

However, since the switching unit 220 according to the embodiment of the present invention may be implemented in a structure in which the switching element is implemented as the bipolar junction transistor Q1 of an NPN type and the emitter terminal E is connected to the electric vehicle supply equipment, the reverse current flowing from the electric vehicle supply equipment to the electric vehicle charging controller 200 may be efficiently blocked at the switching unit 220. The reverse voltage blocking of the switching unit 220 implemented with the NPN-type bipolar junction transistor Q1 may have an effect similar to an electrical isolation by an optocoupler, and has an advantage of reducing manufacturing costs compared to the optocoupler.

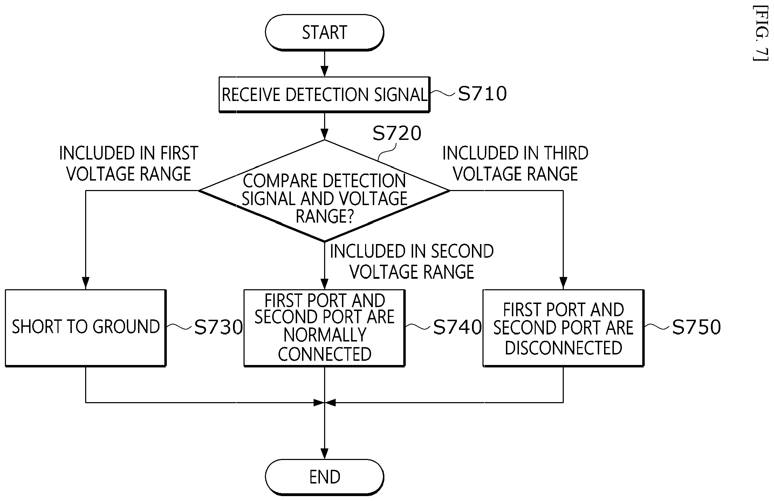

FIG. 7 is a flowchart for describing a port status determination process using the electric vehicle charging controller according to the embodiment of the present invention.

The determination unit 250 may determine a connection status between the first port of the electric vehicle supply equipment and the second port of the electric vehicle corresponding to the first port based on the detection signal.

Specifically, with reference to FIG. 7, the determination unit 250 may receive the detection signal from the detection unit 210 (S710). According to the embodiment, the detection signal may be an analog signal, and the determination unit 250 may include an analog digital converter (ADC) for converting the analog signal to a digital signal.

The determination unit 250 may compare the detection signal to a predetermined voltage range (S720). According to the embodiment, the determination unit 250 may compare the detection signal that is converted to a digital signal to the predetermined voltage range. The predetermined voltage range may include, but is not limited to, the first voltage range to the third voltage range.

As a result of the comparison, when the magnitude of the detection signal is included in the first voltage range, the determination unit 250 may determine that a short to ground has occurred in the line in which the first port and the second port are connected (S730). According to the embodiment, when the magnitude of the detection signal is included in the first voltage range, the determination unit 250 may determine that the line connecting the first ground terminal on the electric vehicle side and the second ground terminal on the electric vehicle supply equipment side is open. According to the embodiment, the first voltage range may be in the range of - 0.2 [V] to 0.2 [V].

As the result of the comparison, when the magnitude of the detection signal is included in the second voltage range having an average value greater than an average value of the first voltage range, the determination unit 250 may determine that the first port and the second port are connected (S740). That is, the determination unit 250 may determine that the first port and the second port are connected normally. According to the embodiment, the second voltage range may be in the range of 1.23 [V] to 1.51 [V].

As the result of the comparison, when the magnitude of the detection signal is included in the third voltage range having an average value greater than an average value of the second voltage range, the determination unit 250 may determine that the first port and the second port are disconnected. For example, when no connection is made between the connector and the inlet or the switching unit 220 is turned off, the magnitude of the detection signal may be included in the third voltage range, in which case the determination unit 250 may determine that the first port and the second port are not electrically connected. According to the embodiment, the third voltage range may be in the range of 4.14 [V] to 5.08 [V]. That is, there may be no overlapping area in the first voltage range to the third voltage range, but it is not limited thereto.

Meanwhile, the determination unit 250 may determine that a short to battery has occurred when the magnitude of the detection signal is included in the third voltage range during the battery charging of the electric vehicle. For example, when the first port and the second port are determined to be normally connected, and the magnitude of the detection signal is included in the third voltage range while the battery is being charged, the determination unit 250 may determine that a short to battery has occurred.

Table 1 below shows the magnitude of the detection signal depending on the connection status.

**[Table 1]**

| Status | Detection | |
|---|---|---|
| | As is | To-be(V) |
| Short to ground | No detection | 0 |
| Connection | High | 1.37 |
| No connection | Low | 4.61 |
| Short to battery | No detection | 4.61 |

Table 1 compares a case of determining the connection status between the first port and the second port using a conventional optocoupler (As is) and a case of determining the connection status between the first port and the second port according to the embodiment of the present invention (To-be). When using the optocoupler as in the conventional method, the determination unit 250 may determine the connection status through the presence or absence of a signal received through the optocoupler. Therefore, when using the optocoupler, the determination unit 250 may determine that the first port and the second port are not connected (no connection status) when the detection signal is at a low level, and may determine that the first port and the second port are in a connection status when the detection signal is at a high level. However, it is not possible to determine other statuses, such as a short to ground or a short to battery.

However, the electric vehicle charging controller 200 according to the embodiment of the present invention receives the detection signal as a voltage value, and indicates different statuses depending on a magnitude of the voltage. According to the embodiment, when the detection signal is 0 [V], the determination unit 250 may determine that a short to ground has occurred because the detection signal is included in the first voltage range of -0.2 [V] to 0.2 [V]. When the detection signal is 1.37 [V], the determination unit 250 may determine that the first port and the second port are in a connection status because the detection signal is included in the second voltage range of 1.23 [V] to 1.51 [V]. When the detection signal is 4.61 [V], the determination unit 250 may determine that the first port and the second port are not connected (no connection status) because the detection signal is included in the third voltage range of 4.14 [V] to 5.08 [V]. In addition, when the detection signal is detected as 4.61 [V] during the battery charging, the determination unit 250 may determine that a short to battery has occurred because the detection signal is included in the third voltage range of 4.14 [V] to 5.08 [V].

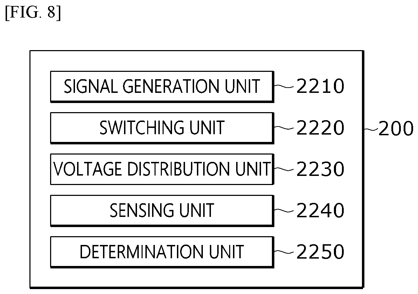

FIG. 8 is a block diagram of an electric vehicle charging controller according to one embodiment of the present invention.

With reference to FIG. 8, an electric vehicle charging controller 200 according to the embodiment of the present invention may include a signal generation unit 2210, a switching unit 2220, a voltage distribution unit 2230, a sensing unit 2240, and a determination unit 2250.

The signal generation unit 2210 may generate a switching signal according to a control signal when the first port of the electric vehicle supply equipment and the second port of the electric vehicle are connected. Here, the first port is a port included in the connector on the electric vehicle supply equipment side, which may mean a proximity detection port on the electric vehicle supply equipment side. The second port is a port included in the inlet on the electric vehicle side, which may mean a proximity detection port on the electric vehicle side. The first port and the second port may be mechanically and electrically coupled by the combination of the connector and the inlet. According to one embodiment, when receiving a control signal from a microcontroller embedded in the electric vehicle side, the switching unit 2220 may generate a switching element based on the control signal and the power of the power supply. In this case, the microcontroller may be formed outside the electric vehicle charging controller 200.

The switching unit 2220 may turn on a switch element connected to one end of the second port through the switching signal. According to one embodiment, when a switch is configured with a bipolar junction transistor, the switching unit 2220 may transmit the switching signal to the base terminal. The switching unit 2220 may include a diode with a cathode terminal connected to a base terminal of the switch, and a reverse voltage (reverse current) applied to the switching unit 2220 may be blocked through the diode.

The voltage distribution unit 2230 may distribute a voltage of the first power source of the electric vehicle by a plurality of resistors electrically connected to the second port. In this case, the first power source may be a direct current voltage of a magnitude of 12 [V].

The sensing unit 2240 may sense the voltage distributed by the plurality of resistors to generate a sensing voltage. The sensing unit 2240 may remove a noise signal that may occur during the process of sensing the distributed voltage.

The determination unit 2250 may determine the connection status with the electric vehicle supply equipment based on a voltage value of the sensing voltage.

The determination unit 2250 may determine that a power source of the supply equipment is shorted to the ground when the voltage value of the sensing voltage is zero. In this case, the voltage value of the sensing voltage is not necessarily zero, and the determination unit 2250 may determine that the power source of the supply equipment is shorted to ground (short to ground) when the voltage value of the sensing voltage is a value corresponding to zero (e.g., a value within a predetermined range including 0[V]).

The determination unit 2250 may determine that the first port and the second port are not electrically connected when the voltage value of the sensing voltage corresponds to a first reference value. Here, corresponding to the first reference value may mean that the voltage value of the sensing voltage is included in a predetermined range including the first reference value. For example, the first reference value may be 4.61 [V], and that the voltage value of the sensing voltage corresponds to the first reference value may mean that the voltage value of the sensing voltage is present within the range of 4.14 to 5.08 [V].

The determination unit 2250 may determine that the first port and the second port are electrically connected when the voltage value of the sensing voltage is less than the first reference value. Here, being less than the first reference value may mean that the voltage value of the sensing voltage is less than a lower limit value of the predetermined range including the first reference value. For example, the first reference value may be 4.61 [V], and the voltage value of the sensing voltage being less than the first reference value may mean that the voltage value of the sensing voltage is less than a lower limit value of 4.14 [V] in the range of 4.14 to 5.08 [V].

When the voltage value of the sensing voltage corresponds to the first reference value while the vehicle is in the process of charging the battery, the connection status may be determined as a status in which the battery of the electric vehicle is shorted.

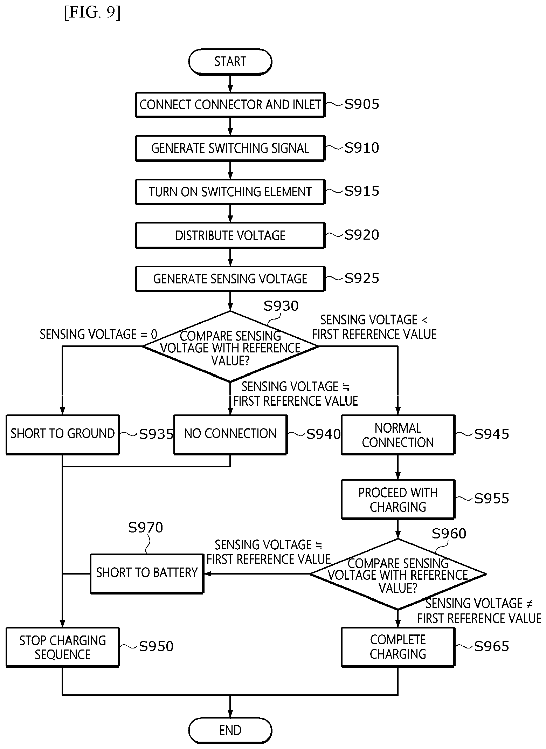

FIG. 9 is a flowchart of a method of determining a connection status of the electric vehicle charging controller according to one embodiment of the present invention.

First, as the connector of the electric vehicle supply equipment and the inlet of the electric vehicle are connected, the first port of the electric vehicle supply equipment and the second port of the electric vehicle are connected (S905).

Then, the electric vehicle charging controller generates a switching signal according to a control signal (S910).

The electric vehicle charging controller turns on the switch element connected to one end of the second port through the switching signal (S915).

Then, the electric vehicle charging controller distributes a voltage of the first power source of the electric vehicle by the plurality of resistors electrically connected to the second port (S920).

Then, the electric vehicle charging controller senses the voltage distributed by the plurality of resistors to generate a sensing voltage (S925).

The electric vehicle charging controller determines a connection status with the electric vehicle supply equipment based on a voltage value of the sensing voltage and a reference value (S930).

The electric vehicle charging controller determines that the supply equipment is shorted to ground when the voltage value of the sensing voltage is zero (S935).

The electric vehicle charging controller determines that the first port and the second port are not electrically connected when the voltage value of the sensing voltage corresponds to the first reference value (S940).

The electric vehicle charging controller determines that the first port and the second port are electrically connected when the voltage value of the sensing voltage is less than the first reference value (S950).

When the connection status with the electric vehicle supply equipment is determined to be the same as operations S935 or S940, the electric vehicle charging controller stops a charging sequence (S950). A reason for the stoppage, that is, a determination result for operations S935 or S940, may be transmitted to the electric vehicle supply equipment and may also be transmitted in the form of an alarm message so that a user may be notified.

Meanwhile, when determined as in operation S945, the electric vehicle charging controller proceeds with charging (S955). According to the embodiment, the electric vehicle charging controller may continue to perform other charging sequences that may be in progress prior to charging, and upon completion of all charging sequences, the electric vehicle supply equipment may begin charging the battery of the electric vehicle.

The electric vehicle charging controller may continue to compare the voltage value of the sensing voltage with the reference value even during the charging process (S960).

During the charging process, when the voltage value of the sensing voltage does not correspond to the first reference value, the electric vehicle charging controller may continue to perform the charging until the charging is completed (or the charging is stopped, etc.) (S965).

In contrast, the electric vehicle charging controller determines that the connection status is a status in which the battery is shorted when the sensed voltage value corresponds to the first reference value while the electric vehicle is in the process of charging the battery (S970).

Then, the electric vehicle charging controller stops the charging sequence (S950).

While the embodiments have been described above, the embodiments are just illustrative and not intended to limit the present invention. It can be appreciated by those skilled in the art that various modifications and applications, which are not described above, may be made to the present embodiment without departing from the intrinsic features of the present embodiment. For example, the respective constituent elements specifically described in the exemplary embodiments may be modified and then carried out. Further, it should be interpreted that the differences related to the modifications and alterations are included in the scope of the present disclosure defined by the appended claims.

## Claims

1. An electric vehicle charging controller comprising:
a switch;
a first resistor having a first end connected to a collector terminal of the switch and a second end connected to a first power source;
a second resistor having a first end connected to the collector terminal of the switch and a second end connected to a signal output terminal;
a third resistor having a first end connected to the second end of the second resistor, and a second end connected to a first ground terminal; and
a diode having a cathode terminal electrically connected to a base terminal of the switch,
wherein an emitter terminal of the switch is electrically connected to a second ground terminal of supply equipment.

2. The electric vehicle charging controller of claim 1, wherein the switch includes a bipolar junction transistor of an NPN type.

3. The electric vehicle charging controller of claim 1, further comprising a capacitor having a first end connected to the signal output terminal and a second end connected to the first ground terminal.

4. An electric vehicle charging controller comprising:
a signal generation unit configured to generate a switching signal according to a control signal when a first port of electric vehicle supply equipment and a second port of an electric vehicle are connected;
a switching unit configured to turn on a switch element connected to one end of the second port through the switching signal;
a voltage distribution unit configured to distribute a voltage supplied by a first power source of the electric vehicle by a plurality of resistors electrically connected to the second port;
a sensing unit configured to generate a sensing voltage by sensing a voltage distributed by the plurality of resistors; and
a determination unit configured to determine a connection status with the electric vehicle supply equipment according to a voltage value of the sensing voltage.

5. The electric vehicle charging controller of claim 4, wherein the determination unit determines that a power source of the supply equipment is shorted to ground when the voltage value of the sensing voltage is 0.

6. The electric vehicle charging controller of claim 4, wherein the determination unit determines that the first port and the second port are not electrically connected when the voltage value of the sensing voltage corresponds to a first reference value.

7. The electric vehicle charging controller of claim 4, wherein the determination unit determines that the first port and the second port are electrically connected when the voltage value of the sensing voltage is less than a first reference value.

8. The electric vehicle charging controller of claim 4, wherein a battery of the electric vehicle is determined to be shorted when the voltage value of the sensing voltage corresponds to a first reference value while the electric vehicle is in a process of charging the battery.

9. A method of determining a connection status using an electric vehicle charging controller, the method comprising:
generating a switching signal according to a control signal when a first port of electric vehicle supply equipment and a second port of an electric vehicle are connected;
turning on a switch element connected to one end of the second port through the switching signal;
distributing a voltage supplied from a first power source of the electric vehicle by a plurality of s resistors electrically connected to the second port;
generating a sensing voltage by sensing a voltage distributed by the plurality of resistors; and
determining a connection status with the electric vehicle supply equipment according to a voltage value of the sensing voltage.

10. The method of claim 9, wherein in the determining of the connection status, a power source of the supply equipment is determined to be shorted to ground when the voltage value of the sensing voltage is 0.

11. The method of claim 9, wherein in the determining of the connection status, the first port and the second port are determined not to be electrically connected when the voltage value of the sensing voltage corresponds to a first reference value.

12. The method of claim 9, wherein in the determining of the connection status, the first port and the second port are determined to be electrically connected when the voltage value of the sensing voltage is less than a first reference value.

13. The method of claim 9, wherein in the determining of the connection status, a battery of the electric vehicle is determined to be shorted when the sensed voltage value corresponds to a first reference value while the electric vehicle is in a process of charging the battery.
